# EUROPEAN PATENT APPLICATION

(11) **EP 4 793 775 A1**
(43) Date of publication of application: **19.08.2026**
(21) Application number: 25213892.0
(22) Date of filing: 06.11.2025
(51) Int. Cl.: G06F 11/10

(54) **SEMICONDUCTOR PACKAGE INCLUDING MEMORY DIES**

(30) Priority: 24.01.2025 KR 20250011486
(71) Applicant: SK hynix Inc., Bubal-eub Icheon-si Gyeonggi-do 17336 (KR)
(72) Inventor: CHOI, Joon Yong, 17336 Icheon-si, Gyeonggi-do (KR)
(74) Representative: Isarpatent

(57) **Abstract**

A semiconductor package includes first data memory dies configured to share a first control bus and a first data bus, the first data memory dies belonging to different ranks, a first error correction memory die configured to share the first control bus with the first data memory dies and connected to a first error correction bus, second data memory dies configured to share a second control bus and a second data bus, second data memory dies belonging to different ranks, and a second error correction memory die configured to share the second control bus with the second data memory dies and connected to the second error correction bus.

## Description

### BACKGROUND

### 1. Technical Field

Embodiments of the present disclosure relate to a semiconductor package including memory dies.

### 2. Related Art

Recently, as application fields using AI and big data have increased, the amount of data to be processed is exploding. Many computer systems (e.g., a data center and a server) require high capacity memory. Applications using a computer system require memory having a higher capacity..

In general, two or more memory dies are included in one semiconductor package due to such a need for the expansion of the capacity. In particular, computer systems, such as a data center and a server, require high reliability even in a semiconductor package.

### SUMMARY

In an embodiment of the present disclosure, a semiconductor package may include first data memory dies configured to share a first control bus and a first data bus, the first data memory dies belonging to different ranks, a first error correction memory die configured to share the first control bus with the first data memory dies and connected to a first error correction bus, second data memory dies configured to share a second control bus and a second data bus, the second data memory dies belonging to different ranks, and a second error correction memory die configured to share the second control bus with the second data memory dies and connected to the second error correction bus.

In an embodiment of the present disclosure, a semiconductor package may include first data memory dies corresponding to ranks of a first channel, respectively, a first error correction memory die corresponding to the ranks of the first channel, second data memory dies corresponding to ranks of a second channel, respectively, and a second error correction memory die corresponding to the ranks of the second channel.

In an embodiment of the present disclosure, a semiconductor package may include first data memory dies configured to share a control bus and a first chip selection signal, a first error correction memory die configured to share the control bus and the first chip selection signal with the first data memory dies, second data memory dies configured to share the control bus and second chip selection signals, and a second error correction memory die configured to share the control bus and the second chip selection signal with the second data memory dies.

In an embodiment of the present disclosure, a semiconductor package may include first data memory dies corresponding to a first rank of a first channel, a first error correction memory die corresponding to the first rank of the first channel, second data memory dies corresponding to a second rank of the first channel, a second error correction memory die corresponding to the second rank of the first channel, third data memory dies corresponding to a first rank of a second channel, a third error correction memory die corresponding to the first rank of the second channel, a fourth data memory dies corresponding to a second rank of the second channel, and a fourth error correction memory die corresponding to the second rank of the second channel.

### BRIEF DESCRIPTION OF THE DRAWINGS

FIG. 1 is a diagram illustrating a configuration of a semiconductor package according to a first embodiment of the present disclosure.
FIG. 2 is a diagram illustrating a configuration of a semiconductor package according to a second embodiment of the present disclosure.
FIG. 3 is a diagram illustrating a configuration of a semiconductor package according to a third embodiment of the present disclosure.
FIG. 4 is a diagram illustrating a configuration of a semiconductor package according to a fourth embodiment of the present disclosure.
FIG. 5 is a diagram illustrating a configuration of a semiconductor package according to a fifth embodiment of the present disclosure.
FIG. 6 is a diagram illustrating a configuration of a semiconductor package according to a sixth embodiment of the present disclosure.

### DETAILED DESCRIPTION

Hereinafter, embodiments according to the technical scope of the present disclosure are described with reference to the accompanying drawings.

Embodiments of the present disclosure may provide a technology for improving the reliability of a semiconductor package including memory dies.

According to embodiments of the present disclosure, the reliability of the semiconductor package including memory dies can be improved.

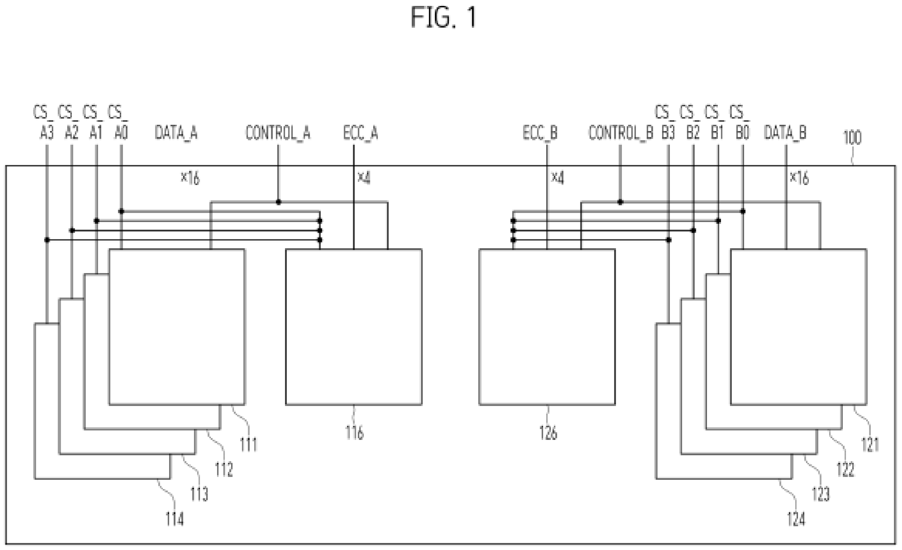

FIG. 1 is a diagram illustrating a configuration of a semiconductor package 100 according to a first embodiment of the present disclosure.

Referring to FIG. 1, the semiconductor package 100 may include first data memory dies 111 to 114, a first error correction memory die 116, second data memory dies 121 to 124, and a second error correction memory die 126.

The first data memory dies 111 to 114 may share a first control bus CONTROL_A and a first data bus DATA_A, and may receive different chip selection signals CS_A0 to CS_A3. That is, the first data memory dies 111 to 114 may be the memory dies of different ranks belonging to the same memory channel (hereinafter referred to as a "channel A"). The first control bus CONTROL_A is a bus that transmits control signals that control the first data memory dies 111 to 114. The control signals that are transmitted to the first control bus CONTROL_A may include a command address signal and a clock signal. The first data bus DATA_A has been illustrated as having 16 bits, and each of the first data memory dies 111 to 114 may be connected to the first data bus DATA_A by using 16 data terminals. That is, each of the first data memory dies 111 to 114 may have an X16 configuration. Furthermore, the first data bus DATA_A may further include one or more lines that transmit one or more data strobe signals that strobe data in addition to 16 data lines.

The first error correction memory die 116 may share the first data memory dies 111 to 114 and the first control bus CONTROL_A, and may be connected to a first error correction bus ECC_A. The first error correction memory die 116 may receive the chip selection signals CS_A0 to CS_A3. The first error correction memory die 116 corresponds to all of the ranks of the channel A and thus has been illustrated as receiving all of the chip selection signals CS_A0 to CS_A3, but may be modified to receive one signal obtained by performing an OR operation on the chip selection signals CS_A0 to CS_A3. The first error correction bus ECC_A is a data bus, and is named an error correction bus because data stored in the first error correction memory die 116 are not normal data, but an error correction code. The first error correction bus ECC_A has been illustrated as having 4 bits, and thus the first error correction memory die 116 may be connected to the first error correction bus ECC_A by using 4 data terminals. That is, the first error correction memory die 116 may have an X4 configuration. Furthermore, the first error correction bus ECC_A may further include one or more lines that transmit one or more data strobe signals that strobe data in addition to 4 data lines.

The second data memory dies 121 to 124 may share a second control bus CONTROL_B and a second data bus DATA_B, and may receive different chip selection signals CS_B0 to CS_B3. That is, the second data memory dies 121 to 124 may be the memory dies of different ranks belonging to the same memory channel (hereinafter referred to as a "channel B"). The second control bus CONTROL_B is a bus that transmits control signals that control the second data memory dies 121 to 124. The control signals that are transmitted to the second control bus CONTROL_B may include a command address signal and a clock signal. The second data bus DATA_B has been illustrated as having 16 bits, and thus each of the second data memory dies 121 to 124 may be connected to the second data bus DATA_B by using 16 data terminals. That is, each of the second data memory dies 121 to 124 may have an X16 configuration. Furthermore, the second data bus DATA_B may further include one or more lines that transmit one or more data strobe signals that strobe data in addition to 16 data lines.

The second error correction memory die 126 may share the second data memory dies 121 to 124 and the second control bus CONTROL_B, and may be connected to the second error correction bus ECC_B. The second error correction memory die 126 may receive the chip selection signals CS_B0 to CS_B3. The second error correction memory die 126 corresponds to all of the ranks of the channel B, and thus has been illustrated as receiving all of the chip selection signals CS_B0 to CS_B3, but may be modified to receive one signal obtained by performing an OR operation on the chip selection signals CS_B0 to CS_B3. The second error correction bus ECC_B is a data bus, and is named an error correction bus because data stored in the second error correction memory die 126 are not normal data, but an error correction code. The second error correction bus ECC_B has been illustrated as having 4 bits, and thus the second error correction memory die 126 may be connected to the second error correction bus ECC_B by using 4 data terminals. That is, the second error correction memory die 126 may have an X4 configuration. Furthermore, the second error correction bus ECC_B may further include one or more lines that transmit one or more data strobe signals that strobe data in addition to 4 data lines.

The first control bus CONTROL_A, the first data bus DATA_A, the first error correction bus ECC_A, the second control bus CONTROL_B, the second data bus DATA_B, and the second error correction bus ECC_B may be connected to a memory controller that controls the semiconductor package 100.

The first data memory dies 111 to 114, the first error correction memory die 116, the second data memory dies 121 to 124, and the second error correction memory die 126 have the same storage capacity. The first data memory dies 111 to 114 and the second memory dies 121 to 124 each have the X16 configuration, but the first error correction memory die 116 and the second error correction memory die 126 each have the X4 configuration. That is, all of the memory dies 111 to 114, 116, 121 to 124, and 126 are the same memory dies, but the memory dies 111 to 114 and 121 to 124 are set as X16 and the memory dies 116 and 126 are set as X4.

After the s25tart of a write operation for the channel A, a first data memory die of a selected rank, among the first data memory dies 111 to 114, that is, a first data memory die corresponding to an activated chip selection signal, among the chip selection signals CS_A0 to CS_A3, may write the data of the first data bus DATA_A. The first error correction memory die 116 may write a first error correction code of the first error correction bus ECC_A. The first error correction code may be an error correction code that corrects an error of the data of the first data bus DATA_A. That is, after the start of a write operation for the channel A, the write operation may be performed in one of the first data memory dies 111 to 114 and the first error correction memory die 116. The storage capacity of each of the first data memory dies 111 to 114 and the storage capacity of the first error correction memory die 116 are identical with each other, but the first data memory dies 111 to 114 each have the X16 configuration and the first error correction memory die 116 has the X4 configuration. Accordingly, such an operation may be possible because the number of bits that are written at a time is different. That is, the first error correction code corresponding to all of data stored in the first data memory dies 111 to 114 may be stored in the first error correction memory die 116 because the number of bits of data that are written after the start of a write operation is four times the number of bits of the first error correction code.

After the start of a read operation for the channel A, data that are read from a first data memory die of a selected rank, among the first data memory dies 111 to 114, that is, a first data memory die corresponding to an activated chip selection signal, among the chip selection signals CS_A0 to CS_A3, may be transmitted to the first data bus DATA_A. The first error correction code that is read from the first error correction memory die 116 may be transmitted to the first error correction bus ECC_A. That is, after the start of a read operation for the channel A, the read operation may be performed in one of the first data memory dies 111 to 114 and the first error correction memory die 116. The memory controller may correct an error of the data transmitted to the first data bus DATA_A by using the first error correction code transmitted to the first error correction bus ECC_A.

After the start of a write operation for the channel B, a second data memory die of a selected rank, among the second data memory dies 121 to 124, that is, a second data memory die corresponding to an activated chip selection signal, among the chip selection signals CS_B0 to CS_B3, may write the data of the second data bus DATA_B. The second error correction memory die 126 may write a second error correction code of the second error correction bus ECC_B. The second error correction code may be an error correction code that corrects an error of the data of the second data bus DATA_B. That is, after the start of a write operation for the channel B, the write operation may be performed in one of the second data memory dies 121 to 124 and the second error correction memory die 126. The storage capacity of each of the second data memory dies 121 to 124 and the storage capacity of the second error correction memory die 126 are identical with each other, but the second data memory dies 121 to 124 each have the X16 configuration and the second error correction memory die 126 has the X4 configuration. Accordingly, such an operation may be possible because the number of bits that are written at a time is different. That is, the second error correction code corresponding to all of data stored in the second data memory dies 121 to 124 may be stored in the second error correction memory die 126 because the number of bits of data that are written after the start of a write operation is four times the number of bits of the second error correction code.

After the start of a read operation for the channel B, data that are read from a second data memory die of a selected rank, among the second data memory dies 121 to 124, that is, a second data memory die corresponding to an activated chip selection signal, among the chip selection signals CS_B0 to CS_B3, may be transmitted to the second data bus DATA_B. The second error correction code that is read from the second error correction memory die 126 may be transmitted to the second error correction bus ECC_B. That is, after the start of a read operation for the channel B, the read operation may be performed in one of the second data memory dies 121 to 124 and the second error correction memory die 126. The memory controller may correct an error of the data transmitted to the second data bus DATA_B by using the second error correction code transmitted to the second error correction bus ECC_B.

The semiconductor package 100 may include the first error correction memory die 116 that stores the first error correction code for correcting an error of the first data memory dies 111 to 114 of the channel A and the second error correction memory die 126 that stores the second error correction code for correcting an error of the second data memory dies 121 to 124 of the channel B. Accordingly, an error occurring in the semiconductor package 100 can be corrected. As a result, the reliability of the semiconductor package 100 can be improved. Furthermore, the complexity and costs of the semiconductor package 100 can be reduced because all of the memory dies 111 to 114, 116, 121 to 124, and 126 can be constructed as the same memory die.

The memory dies 111 to 114, 116, 121 to 124, and 126 may be vertically stacked and horizontally arranged within the semiconductor package 100. For example, the memory dies 111 to 114 and 116 of the channel A may be vertically stacked, and the memory dies 121 to 124 and 126 of the channel B may be vertically stacked alongside the memory dies 111 to 114 and 116. All of the memory dies 111 to 114, 116, 121 to 124, and 126 may be vertically stacked or all of the memory dies 111 to 114, 116, 121 to 124, and 126 may be horizontally arranged.

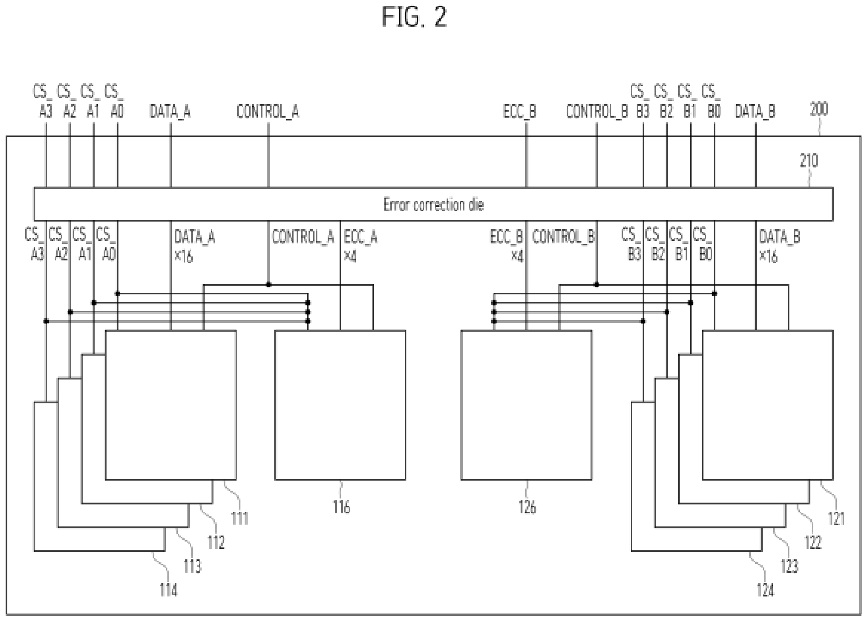

FIG. 2 is a diagram illustrating a configuration of a semiconductor package 200 according to a second embodiment of the present disclosure.

The semiconductor package 200 may further include an error correction die 210 compared to the semiconductor package 100 of FIG. 1.

The error correction die 210 performs a role of buffering the data of the buses CONTROL_A, DATA_A, CONTROL_B, DATA_B, CS_A0 to CS_A3, and CS_B0 to CS_B3, may generate error correction codes to be stored in the error correction memory dies 116 and 126 after the start of a write operation, and may perform an error correction operation after the start of a read operation.

After the start of a write operation for the channel A, the error correction die 210 may generate a first error correction code by encoding the data of the data bus DATA_A and transmit the first error correction code to the first error correction bus ECC_A. Furthermore, after the start of a read operation for the channel A, the error correction die 210 may correct an error of the data of the first data bus DATA_A by using the first error correction code of the first error correction bus ECC_A and transmit the data to the memory controller through the first data bus DATA_A.

After the start of a write operation for the channel B, the error correction die 210 may generate a second error correction code by encoding the data of the data bus DATA_B and transmit the second error correction code to the second error correction bus ECC_B. Furthermore, after the start of a read operation for the channel B, the error correction die 210 may correct an error of the data of the second data bus DATA_B by using the second error correction code of the second error correction bus ECC_B and transmit the data to the memory controller through the second data bus DATA_B.

If the semiconductor package 200 is equipped with the error correction die 210, the semiconductor package 200 autonomously generates an error correction code and executes an error correction operation. The memory controller might not be involved in the generation of the error correction code and the execution of the error correction operation.

FIG. 2 has illustrated that the semiconductor package 200 includes one error correction die 210, but may include more error correction dies, such as that an error correction die is independently provided for each channel according to an embodiment.

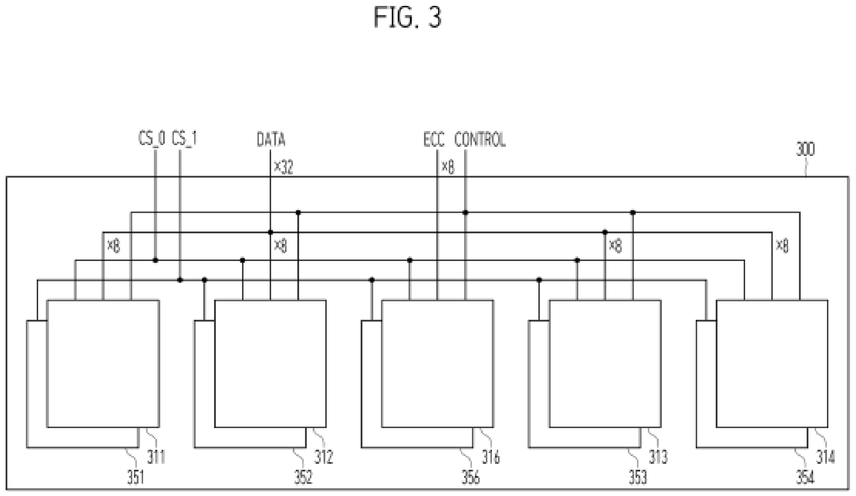

FIG. 3 is a diagram illustrating a configuration of a semiconductor package 300 according to a third embodiment of the present disclosure.

Referring to FIG. 3, the semiconductor package 300 may include first data memory dies 311 to 314, a first error correction memory die 316, second data memory dies 351 to 354, and a second error correction memory die 356.

The first data memory dies 311 to 314 may share a control bus CONTROL and a chip selection signal CS_0, and may be connected to different data buses. 32 bits of the data bus DATA are divided every 8 bits, and 8 bits are connected to each of the first data memory dies 311 to 314. Accordingly, the data bus DATA may be independent with respect to the first data memory dies 311 to 314. Each of the first memory dies 311 to 314 may be connected to the data bus DATA by using 8 data terminals. That is, each of the first memory dies 311 to 314 may have an X8 configuration. The data bus DATA may further include lines that strobe data in addition to 32 data lines. The control bus CONTROL is a bus that transmits control signals that control the first data memory dies 311 to 314. The control signals that are transmitted to the control bus CONTROL may include a command address signal and a clock signal.

The first error correction memory die 316 may share the control bus CONTROL and the chip selection signal CS_0 with the first data memory dies 311 to 314, and may be connected to an error correction bus ECC. That is, the first error correction memory die 316 and the first memory dies 311 to 314 may belong to the same channel and the same rank. The error correction bus ECC is a data bus, and is named the error correction bus ECC because data stored in the first error correction memory die 316 are an error correction code not normal data. The first error correction memory die 316 may have an X8 configuration because the error correction bus ECC has been illustrated as having 8 bits. Furthermore, the error correction bus ECC may further include one or more lines that transmit one or more data strobe signals in addition to 8 data lines.

The second data memory dies 351 to 354 may share the control bus CONTROL and a chip selection signal CS_1, and may be connected to different data buses. 32 bits of the data bus DATA are divided every 8 bits, and 8 bits are connected to each of the second data memory dies 351 to 354. Accordingly, the data bus DATA may be independent with respect to the second data memory dies 351 to 354. Each of the second data memory dies 351 to 354 may be connected to the data bus DATA by using 8 data terminals. That is, each of the second data memory dies 351 to 354 may have an X8 configuration. The second data memory dies 351 to 354 may share the data bus DATA with the first data memory dies 311 to 314. For example, the second data memory die 351 may share the data bus DATA with the first data memory die 311, and the second data memory die 353 may share the data bus DATA with the first data memory die 313.

The second error correction memory die 356 may share the control bus CONTROL and the chip selection signal CS_1 with the second data memory dies 351 to 354, and may be connected to the error correction bus ECC. That is, the second error correction memory die 356 and the second data memory dies 351 to 354 may belong to the same channel and the same rank. The second error correction memory die 356 may share the error correction bus ECC with the first error correction memory die 316.

The control bus CONTROL, the data bus DATA, and the error correction bus ECC may be connected to a memory controller that controls the semiconductor package 300.

The first data memory dies 311 to 314, the first error correction memory die 316, the second data memory dies 351 to 354, and the second error correction memory die 356 have the same storage capacity, and may have the same X8 configuration. That is, all of the memory dies 311 to 314, 316, 351 to 354, and 356 may be the same memory dies.

The semiconductor package 300 may include one channel and two ranks. After the start of a write operation for a rank0 corresponding to the chip selection signal CS_0, the data of the data bus DATA may be written in the first data memory dies 311 to 314, and a first error correction code of the error correction bus ECC may be written in the first error correction memory die 316. The first error correction code may be an error correction code corresponding to the data written in the first data memory dies 311 to 314. The number of bits of the data written after the start of the write operation may be four times the number of bits of the first error correction code.

After the start of a read operation for the rank0 corresponding to the chip selection signal CS_0, data that are read from the first data memory dies 311 to 314 may be transmitted to the data bus DATA, and the first error correction code that is read from the first error correction memory die 316 may be transmitted to the error correction bus ECC. The memory controller may correct an error of the data transmitted to the data bus DATA by using the first error correction code transmitted to the error correction bus.

After the start of a write operation for a rank1 corresponds to the chip selection signal CS_1, the data of the data bus DATA may be written in the second data memory dies 351 to 354, and a second error correction code of the error correction bus ECC may be written in the second error correction memory die 356. The second error correction code may be an error correction code corresponding to the data written in the second data memory dies 351 to 354. The number of bits of the data written after the start of the write operation may be four times the number of bits of the second error correction code.

After the start of a read operation for a rank1 corresponding to the chip selection signal CS_1, data that are read from the second data memory dies 351 to 354 may be transmitted to the data bus DATA, and the second error correction code that is read from the second error correction memory die 356 may be transmitted to the error correction bus ECC. The memory controller may correct an error of the data transmitted to the data bus DATA by using the second error correction code transmitted to the error correction bus ECC.

The semiconductor package 300 may include the first error correction memory die 316 that stores the first error correction code for correcting an error of data stored in the first data memory dies 311 to 314 of the rank0 and the second error correction memory die 356 that stores the second error correction code for correcting an error of data stored in the second data memory dies 351 to 354 of the rank1. Accordingly, an error occurring in the semiconductor package 300 can be corrected, and as a result, the reliability of the semiconductor package 300 can be improved. Furthermore, the complexity and costs of the semiconductor package 300 can be reduced because all of the memory dies 311 to 314, 316, 351 to 354, 356 may be constructed to have the same memory die.

The memory dies 311 to 314, 316, 351 to 354, and 356 may be vertically stacked and horizontally arranged within the semiconductor package 300.

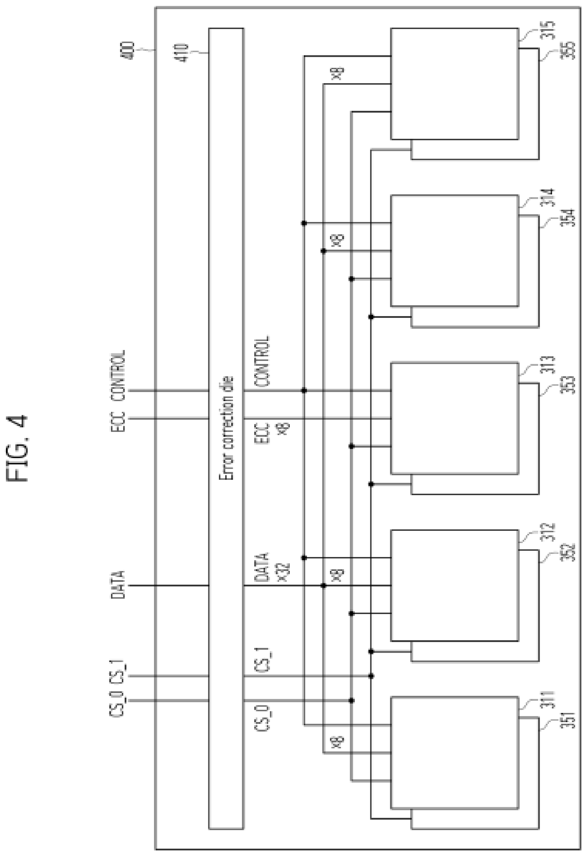

FIG. 4 is a diagram illustrating a configuration of a semiconductor package 400 according to a fourth embodiment of the present disclosure.

The semiconductor package 400 further includes an error correction die 410 compared to the semiconductor package 300 of FIG. 3.

The error correction die 410 may perform a role of buffering the data of the buses CONTROL, DATA, CS_0, and CS_1, may generate error correction codes to be stored in the error correction memory dies 316 and 356 after the start of a write operation, and may perform an error correction operation after the start of a read operation.

After the start of a write operation for the rank0, the error correction die 410 may generate a first error correction code by encoding the data of the data bus DATA and transmit the first error correction code to the error correction bus ECC. Furthermore, after the start of a read operation for the rank0, the error correction die 410 may correct an error of the data of the data bus DATA by using the first error correction code of the error correction bus ECC and transmit the data to the memory controller through the data bus DATA.

After the start of a write operation for the rank1, the error correction die 410 may generate a second error correction code by encoding the data of the data bus DATA and transmit the second error correction code to the error correction bus ECC. Furthermore, after the start of a read operation for the rank1, the error correction die 410 may correct an error of the data of the data bus DATA by using the second error correction code of the error correction bus ECC and transmit the data to the memory controller through the data bus DATA.

If the semiconductor package 400 is equipped with the error correction die 410, the semiconductor package 400 autonomously generates an error correction code and executes an error correction operation. The memory controller might not be involved in the generation of the error correction code and the execution of the error correction operation.

FIG. 4 has illustrated that the semiconductor package 400 includes one error correction die 410, but may include more error correction dies, such as that the error correction die is provided for each rank according to an embodiment.

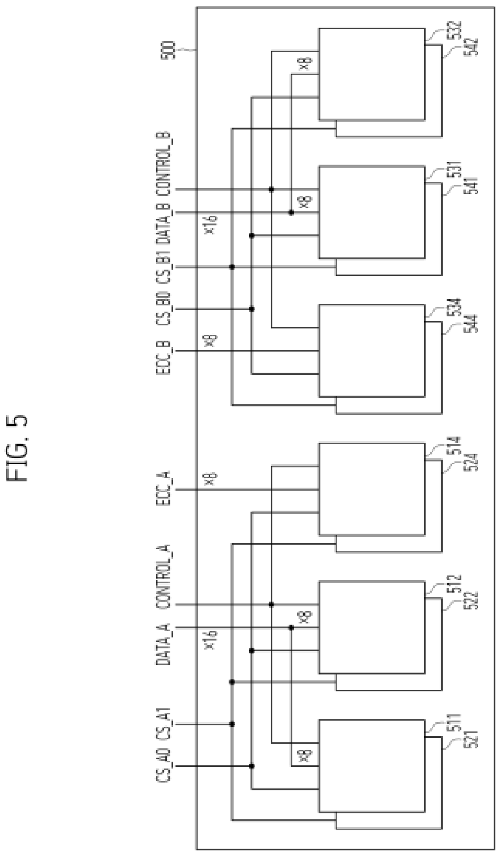

FIG. 5 is a diagram illustrating a configuration of a semiconductor package 500 according to a fifth embodiment of the present disclosure.

Referring to FIG. 5, the semiconductor package 500 may include first data memory dies 511 and 512, a first error correction memory die 514, second data memory dies 521 and 522, a second error correction memory die 524, third data memory dies 531 and 532, a third error correction memory die 534, fourth data memory dies 541 and 542, and a fourth error correction memory die 544.

The semiconductor package 500 may include two channels of a channel A and a channel B and two ranks of a rank0 and a rank1 for each channel.

The first data memory dies 511 and 512 and the first error correction memory die 514 may share a first control bus CONTOL_A and a chip selection signal CS_A0. That is, the first data memory dies 511 and 512 and the first error correction memory die 514 may belong to the rank0 of the channel A. The first data memory dies 511 and 512 are connected to different data buses. 16 bits of a first data bus DATA_A may be divided into two, and 8 bits of the first data bus DATA_A may be connected to each of the first data memory dies 511 and 512. That is, the first data memory dies 511 and 512 may each have an X8 configuration. The first error correction memory die 514 may be connected to a first error correction bus ECC_A, and may have an X8 configuration.

The second data memory dies 521 and 522 and the second error correction memory die 524 may share the first control bus CONTOL_A and a chip selection signal CS_A1. That is, the second data memory dies 521 and 522 and the second error correction memory die 524 may belong to the rank1 of the channel A. The second data memory dies 521 and 522 are connected to different data buses. 16 bits of the first data bus DATA_A may be divided into two. 8 bits of the first data bus DATA_A may be connected to each of the second data memory dies 521 and 522. That is, the second data memory dies 521 and 522 may each have an X8 configuration. The second error correction memory die 524 may be connected to the first error correction bus ECC_A, and may have an X8 configuration.

The third data memory dies 531 and 532 and the third error correction memory die 534 may share a second control bus CONTOL_B and a chip selection signal CS_B0. That is, the third data memory dies 531 and 532 and the third error correction memory die 534 may belong to the rank0 of the channel B. The third data memory dies 531 and 532 are connected to different data buses. 16 bits of a second data bus DATA_B may be divided into two. 8 bits of the second data bus DATA_B may be connected to each of the third data memory dies 531 and 532. That is, the third data memory dies 531 and 532 may each have an X8 configuration. The third error correction memory die 534 may be connected to a second error correction bus ECC_B, and may have an X8 configuration.

The fourth data memory dies 541 and 542 and the fourth error correction memory die 544 may share the second control bus CONTOL_B and a chip selection signal CS_B1. That is, the fourth data memory dies 541 and 542 and the fourth error correction memory die 544 may belong to the rank1 of the channel B. The fourth data memory dies 541 and 542 are connected to different data bus. 16 bits of the second data bus DATA_B may be divided into two. 8 bits of the second data bus DATA_B may be connected to each of the fourth data memory dies 541 and 542. That is, the third data memory dies 541 and 542 may each have an X8 configuration. The fourth error correction memory die 544 may be connected to the second error correction bus ECC_B, and may have an X8 configuration.

The memory dies 511, 512, 514, 521, 522, 524, 531, 532, 534, 541, 542, and 544 of the semiconductor package 500 may have the same capacity and the same X8 configuration. That is, all of the memory dies 511, 512, 514, 521, 522, 524, 531, 532, 534, 541, 542, and 544 may be the same memory dies.

After the start of write and read operations for the rank0 of the channel A, the write and read operations may be performed on the first data memory dies 511 and 512 and the first error correction memory die 514. After the start of write and read operations for the rank1 of the channel A, the write and read operations may be performed on the second data memory dies 521 and 522 and the second error correction memory die 524. The number of bits of data may be twice the number of bits of an error correction code because the first data bus DATA_A has 16 bits and the first error correction bus ECC_A has 8 bits.

After the start of write and read operations for the rank0 of the channel B, the write and read operations may be performed on the third data memory dies 531 and 532 and the third error correction memory die 534. After the start of write and read operations for the rank1 of the channel B, the write and read operations may be performed on the fourth data memory dies 541 and 542 and the fourth error correction memory die 544. The number of bits of data may be twice the number of bits of an error correction code because the second data bus DATA_B has 16 bits and the second error correction bus ECC_B has 8 bits.

The semiconductor package 500 may include the first error correction memory die 514 that stores a first error correction code for correcting an error of data stored in the first data memory dies 511 and 512 belonging to the rank0 of the channel A, the second error correction memory die 524 that stores a second error correction code for correcting an error of data stored in the second data memory dies 521 and 522 belonging to the rank1 of the channel A, the third error correction memory die 534 that stores a third error correction code for correcting an error of data stored in the third data memory dies 531 and 532 belonging to the rank0 of the channel B, and the fourth error correction memory die 544 that stores a fourth error correction code for correcting an error of data stored in the fourth data memory dies 541 and 542 belonging to the rank1 of the channel B. Accordingly, an error occurring in the semiconductor package 500 can be corrected, and as a result, the reliability of the semiconductor package 500 can be improved. Furthermore, the complexity and costs of the semiconductor package 500 can be reduced because all of the memory dies 511, 512, 514, 521, 522, 524, 531, 532, 534, 541, 542, and 544 can be constructed to have the same memory die.

The memory dies 511, 512, 514, 521, 522, 524, 531, 532, 534, 541, 542, and 544 may be vertically stacked and horizontally arranged within the semiconductor package 500.

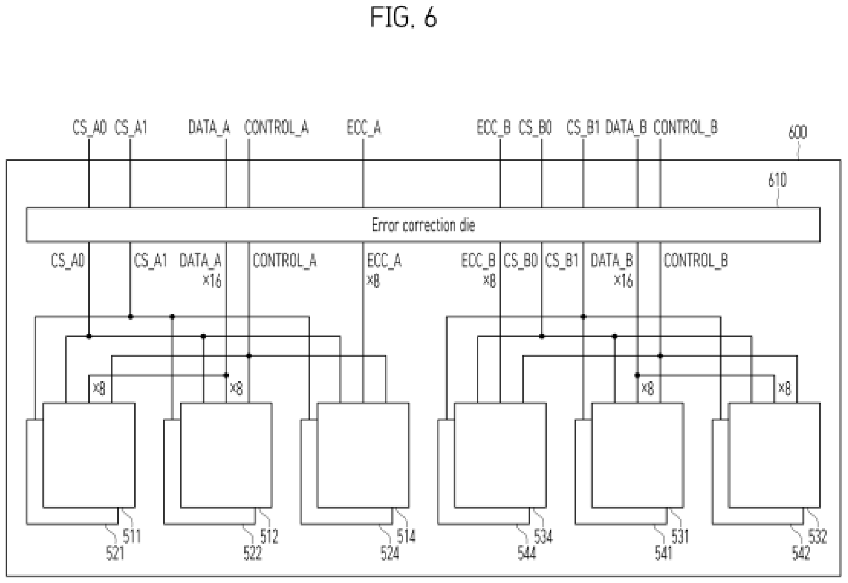

FIG. 6 is a diagram illustrating a configuration of a semiconductor package 600 according to a sixth embodiment of the present disclosure.

The semiconductor package 600 further includes an error correction die 610 compared to the semiconductor package 500 of FIG. 5.

The error correction die 610 may perform a role of buffering the data of the buses CONTROL_A, DATA_A, CONTROL_B, DATA_B, CS_A0, CS_A1, CS_B0, and CS_B1, may generate an error correction code to be stored in each of the error correction memory dies 515, 524, 534, and 544 after the start of a write operation, and may perform an error correction operation after the start of a read operation.

If the semiconductor package 600 is equipped with the error correction die 610, the semiconductor package 600 autonomously generates an error correction code and executes an error correction operation. The memory controller might not be involved in the generation of the error correction code and the execution of the error correction operation.

FIG. 6 has illustrated that the semiconductor package 600 is equipped with one error correction die 610, but may include more error correction dies, such as that an error correction die is provided for each channel according to an embodiment.

Although embodiments according to the technical scope of the present disclosure have been described above with reference to the accompanying drawings, the embodiments have been provided to merely describe embodiments according to the concept of the present disclosure, and the present invention is not limited to the embodiments. A person having ordinary knowledge in the art to which the present disclosure pertains may substitute, modify, and change the embodiments in various ways without departing from the technical scope of the present disclosure written in the claims. Such substitutions, modifications, and changes may be said to belong to the scope of the present disclosure. Furthermore, the embodiments may be combined to form additional embodiments.

## Claims

1. A semiconductor package comprising:
first data memory dies configured to share a first control bus and a first data bus, the first data memory dies belonging to different ranks;
a first error correction memory die configured to share the first control bus with the first data memory dies and connected to a first error correction bus;
second data memory dies configured to share a second control bus and a second data bus, the second data memory dies belonging to different ranks; and
a second error correction memory die configured to share the second control bus with the second data memory dies and connected to a second error correction bus.

2. The semiconductor package of claim 1, wherein:
during a read or write operation for one of the first data memory dies, the read or write operation is performed on the first error correction memory die; and
during a read or write operation for one of the second data memory dies, the read or write operation is performed on the second error correction memory die.

3. The semiconductor package of claim 2, wherein:
the first error correction memory die is configured to store a first error correction code for correcting an error of data stored in the first data memory dies; and
the second error correction memory die is configured to store a second error correction code for correcting an error of data stored in the second data memory dies.

4. The semiconductor package of claim 3, wherein:
a number of bits of data that are input and output during the read or write operation for one of the first data memory dies is greater than a number of bits of the first error correction code that is input and output during the read or write operation for the first error correction memory die; and
a number of bits of data that are input and output during the read or write operation for one of the second data memory dies is greater than a number of bits of the second error correction code that is input and output during the read or write operation for the second error correction memory die.

5. The semiconductor package of claim 4, wherein:
a capacity of each of the first data memory dies and a capacity of the first error correction memory die are identical with each other; and
a capacity of each of the second data memory dies and a capacity of the second error correction memory die are identical with each other.

6. The semiconductor package of claim 4, wherein:
a number of the first data memory dies is N, where N is an integer equal to or greater than 2;
a number of data terminals that are used in each of the first data memory dies is N times a number of data terminals that are used in the first error correction memory die;
a number of the second data memory dies is N; and
a number of data terminals that are used in each of the second data memory dies is N times a number of data terminals that are used in the second error correction memory die.

7. The semiconductor package of claim 3, further comprising one or more error correction dies each configured to:
generate the first error correction code to be written in the first error correction memory die during the write operation for one of the first data memory dies, and correct an error of data that are read from one of the first data memory dies by using the first error correction code that is read from the first error correction memory die during the read operation for one of the first data memory dies; and
generate the second error correction code to be written in the second error correction memory die during the write operation for one of the second data memory dies, and correct an error of data that are read from one of the second data memory dies by using the second error correction code that is read from the second error correction memory die during the read operation for one of the second data memory dies.

8. The semiconductor package of claim 6, wherein:
the first data memory dies are configured to receive (1-1)-th to (1-N)-th chip selection signals, respectively;
the first error correction memory die is configured to receive the (1-1)-th to (1-N)-th chip selection signals;
the second data memory dies are configured to receive (2-1)-th to (2-N)-th chip selection signals, respectively; and
the second error correction memory die is configured to receive the (2-1)-th to (2-N)-th chip selection signals.

9. A semiconductor package comprising:
first data memory dies configured to share a control bus and a first chip selection signal;
a first error correction memory die configured to share the control bus and the first chip selection signal with the first data memory dies;
second data memory dies configured to share the control bus and second chip selection signals; and
a second error correction memory die configured to share the control bus and the second chip selection signal with the second data memory dies.

10. The semiconductor package of claim 9, wherein:
a number of each of the first data memory dies and the second data memory dies is N, where N is an integer equal to or greater than 2;
each of the first data memory dies and the first error correction memory die uses a different one of first to (N+1)-th data buses; and
each of the second data memory dies and the second error correction memory die uses a different one of the first to (N+1)-th data buses.

11. The semiconductor package of claim 10, wherein:
during a write operation for the first data memory dies, a first error correction code corresponding to data that are written in the first data memory dies is written in the first error correction memory die; and
during a write operation for the second data memory dies, a second error correction code corresponding to data that are written in the second data memory dies is written in the second error correction memory die.

12. The semiconductor package of claim 11, wherein:
each of the first data memory dies and the first error correction memory die have an identical storage capacity and use an identical number of data terminals; and
each of the second data memory dies and the second error correction memory die have an identical storage capacity and use an identical number of data terminals.

13. A semiconductor package comprising:
first data memory dies corresponding to a first rank of a first channel;
a first error correction memory die corresponding to the first rank of the first channel;
second data memory dies corresponding to a second rank of the first channel;
a second error correction memory die corresponding to the second rank of the first channel;
third data memory dies corresponding to a first rank of a second channel;
a third error correction memory die corresponding to the first rank of the second channel;
a fourth data memory dies corresponding to a second rank of the second channel; and
a fourth error correction memory die corresponding to the second rank of the second channel.

14. The semiconductor package of claim 13, wherein:
during a read or write operation for the first rank of the first channel, the read or write operation is performed on the first data memory dies and the first error correction memory die;
during a read or write operation for the second rank of the first channel, the read or write operation is performed on the second data memory dies and the second error correction memory die;
during a read or write operation for the first rank of the second channel, the read or write operation is performed on the third data memory dies and the third error correction memory die and
during a read or write operation for the second rank of the second channel, the read or write operation is performed on the fourth data memory dies and the fourth error correction memory die.

15. The semiconductor package of claim 14, wherein each of the first data memory dies, the first error correction memory die, each of the second data memory dies, the second error correction memory die, each of the third data memory dies, the third error correction memory die, each of the fourth data memory dies, and the fourth error correction memory die have an identical storage capacity and use an identical number of data terminals.
